# FASCICULE DE BREVET EUROPEEN

(11) **EP 4 309 216 B1**
(45) Date de publication et mention de la délivrance du brevet: **26.03.2025**
(21) Numéro de dépôt: 22714481.3
(22) Date de dépôt: 17.03.2022
(51) Int. Cl.: H01L 21/02, H01L 21/18, H10N 30/072, H10N 30/073, H10N 30/086

(54) **PROCÉDÉ DE TRANSFERT D'UNE COUCHE D'UNE HÉTÉROSTRUCTURE**
VERFAHREN ZUM TRANSFER EINER SCHICHT EINER HETEROSTRUKTUR
METHOD FOR TRANSFERRING A LAYER OF A HETEROSTRUCTURE

(30) Priorité: 19.03.2021 FR 2102779
(43) Date de publication de la demande: 24.01.2024
(73) Titulaire: SOITEC, 38190 Bernin (FR)
(72) Inventeur: BARGE, Thierry, 38190 BERNIN (FR)
(74) Mandataire: IP Trust
(86) Numéro de dépôt international: PCT/FR2022/050478
(87) Numéro de publication internationale: WO 2022/195225

(56) Documents cités:
- EP-A1- 0 854 500
- EP-A2- 2 469 709
- FR-A1- 2 925 221
- FR-A1- 2 935 535
- US-A1- 2012 126 669
- US-A1- 2020 098 974
- INOUE F ET AL: "Edge trimming for surface activated dielectric bonded wafers", MICROELECTRONIC ENGINEERING, vol. 167, 18 October 2016 (2016-10-18), pages 10 - 16, XP055863779, ISSN: 0167-9317, DOI: 10.1016/j.mee.2016.10.014

## Description

### Domaine technique

L'invention concerne un procédé de transfert d'une couche d'une hétérostructure sur un substrat receveur.

### Etat de la technique

Dans le domaine de la microélectronique, les procédés de transfert de couche sont utilisés pour transférer une couche d'un premier substrat, dit substrat donneur, sur un second substrat, dit substrat receveur.

Le procédé Smart Cut^{™} est ainsi bien connu pour permettre la fabrication de substrats de type semi-conducteur sur isolant, mais aussi d'autres substrats composites, par exemple des substrats de type piézoélectrique sur isolant. Ce procédé comprend la formation d'une zone de fragilisation par implantation d'espèces atomiques dans le substrat donneur, afin d'y délimiter une couche d'intérêt à transférer, le collage du substrat donneur sur le substrat receveur, puis le détachement du substrat donneur le long de la zone de fragilisation, de sorte à transférer la couche d'intérêt sur le substrat receveur.

Dans certaines situations, il n'est pas possible de transférer directement une couche d'un substrat donneur sur le substrat receveur, par exemple en raison de contraintes liées au procédé de transfert. Plus particulièrement, le collage du substrat donneur sur le substrat receveur peut être réalisé par l'intermédiaire de couches d'oxyde de silicium formées au préalable sur la surface de chacun des deux substrats. Toutefois, pour obtenir le détachement de la couche d'intérêt à transférer, il est nécessaire de procéder à un recuit, dans une plage de température de 100°C à 600°C. Lorsque le substrat donneur et le substrat receveur ont des coefficients de dilatation thermiques différents - ce qui est le cas par exemple entre un substrat donneur en un matériau piézoélectrique et un substrat receveur en silicium - ledit recuit engendre une déformation significative (« bow » selon la terminologie anglo-saxonne) de l'assemblage des deux substrats, qui est préjudiciable au transfert dans la mesure où cela peut induire une casse des substrats.

Pour minimiser une telle déformation, il est possible de former un substrat intermédiaire dit pseudo-substrat donneur, dans lequel le substrat donneur est assemblé sur un substrat support temporaire.

Le procédé de transfert comprend alors une étape préalable de formation du pseudo-substrat donneur, par collage du substrat donneur sur le substrat support, une étape d'amincissement du substrat donneur, une étape d'implantations d'espèces atomiques dans le pseudo-substrat donneur pour délimiter la couche d'intérêt à transférer, une étape de collage du pseudo-substrat donneur sur le substrat receveur final, et une étape de détachement du pseudo-substrat donneur le long de la zone de fragilisation pour transférer la couche d'intérêt sur le substrat receveur.

La demande WO 2019/186032 au nom du demandeur décrit un tel procédé adapté à la formation d'un substrat de type piézoélectrique sur isolant.

Un problème qui se pose lors de la fabrication d'un tel pseudo-substrat donneur est sa fragilité. En effet, les substrats utilisés en microélectronique sont pourvus d'un chanfrein périphérique qui permet d'éviter la présence d'angles vifs, particulièrement fragiles, au niveau du bord des substrats. Compte tenu de la finesse du substrat donneur aminci, ledit substrat présente un bord incliné et forme ainsi une lame très fine et cassante.

Or, les débris générés par la casse de cette lame sont susceptibles de contaminer la ligne de production et les substrats mis en oeuvre sur cette ligne.

Le document EP 2 469 709 divulgue un procédé de fabrication d'une hétérostructure dans lequel un substrat piézoélectrique est meulé sur son périmètre, collé à un substrat de support et aminci ensuite.

L'article d' Inoue et al, Edge trimming for surface activated dielectric bonded wafers, Microelectronic Engineering, vol. 167, 18 octobre 2016, pp 10-16 et les documents US 2012/126669, US 2020/098974, FR 2 935 535 et EP 0 854 500 décrivent des procédés de détourage de substrats piézoélectriques et/ou semi-conducteurs collés, avant ou après le collage. Le transfert d'une couche utile à l'aide des techniques de double collage de substrats est connu de FR 2 925 221, par exemple.

### Brève description de l'invention

Un but de la présente invention est donc de permettre la fabrication d'une hétérostructure (pseudo-substrat donneur) comprenant un substrat donneur aminci tout en minimisant le risque de casse dudit substrat donneur et le transfert d'une couche de ladite hétérostructure sur un substrat receveur.

A cet effet, l'invention propose un procédé de de transfert d'une couche d'une hétérostructure sur un substrat receveur, comprenant les étapes successives suivantes :
- formation de l'hétérostructure, comportant les etapes de :
- fourniture d'un substrat donneur d'un premier matériau et d'un substrat support d'un second matériau,
- collage du substrat donneur sur le substrat support,
- amincissement du substrat donneur, de sorte à former ladite hétérostructure (H) comprenant le substrat donneur aminci sur le substrat support,
- -retrait d'une portion périphérique du substrat donneur,
- formation d'une zone de fragilisation dans le substrat donneur aminci de sorte à délimiter une couche du premier matériau à transférer,
- collage de ladite hétérostructure sur un substrat receveur, la couche du premier matériau à transférer étant située à l'interface de collage,
- détachement du substrat donneur le long de la zone de fragilisation de sorte à transférer la couche du premier matériau sur le substrat receveur.

Le retrait de la portion annulaire périphérique du substrat donneur (également appelé « détourage »), qui peut être réalisé avant ou après le collage dudit substrat sur le substrat support, permet d'éviter la formation d'une lame cassante.

Selon d'autres caractéristiques avantageuses mais optionnelles dudit procédé, éventuellement combinées lorsque cela est techniquement possible :
- l'étape de retrait de la portion périphérique du substrat donneur est réalisée avant le collage du substrat donneur sur le substrat support ;
- l'étape de retrait de la portion périphérique du substrat donneur est réalisée après le collage du substrat donneur sur le substrat support ;
- le retrait de la portion périphérique du substrat donneur comprend en outre un retrait d'une portion périphérique du substrat support en regard dudit substrat donneur ;
- l'étape de retrait de la portion périphérique du substrat donneur est réalisée après au moins une partie de l'amincissement du substrat donneur ;
- le substrat donneur est collé sur le substrat support par une couche de collage polymérique ;
- la portion périphérique retirée du substrat donneur présente une largeur comprise entre 300 et 1000 µm, de préférence entre 300 et 500 µm à partir du bord du substrat donneur ;
- le substrat donneur est collé sur le substrat support par adhésion moléculaire ;
- la portion périphérique retirée du substrat donneur présente une largeur comprise entre 1 et 3 mm, de préférence entre 2 et 3 mm à partir du bord du substrat donneur ;
- le retrait de la portion périphérique comprend :
   - la mise en place du substrat donneur sur un support mobile en rotation autour d'un premier axe ;
   - l'usinage du substrat donneur par une roue abrasive en rotation autour d'un second axe parallèle au premier axe, la roue abrasive étant entraînée en outre en translation selon le second axe ;
- le retrait de la portion périphérique comprend :
   - la mise en place du substrat donneur sur un support mobile en rotation autour d'un premier axe ;
   - l'usinage du substrat donneur par une roue abrasive en rotation autour d'un second axe perpendiculaire au premier axe ;
- le procédé comprend en outre une étape de polissage du substrat donneur après le retrait de la portion périphérique ;
- le substrat donneur comprend un matériau piézoélectrique ou un matériau semi-conducteur ;
- le substrat donneur aminci présente une épaisseur comprise entre 10 et 100 µm, de préférence entre 10 et 50 µm ;
- le substrat support comprend du silicium, du verre, du quartz, du saphir, une céramique, et/ou du nitrure d'aluminium polycristallin.

Selon d'autres caractéristiques avantageuses mais optionnelles dudit procédé, éventuellement combinées lorsque cela est techniquement possible :
- avant le collage de l'hétérostructure sur le substrat receveur, on forme une couche intermédiaire sur le substrat donneur et/ou le substrat receveur ;
- la couche intermédiaire comprend de l'oxyde de silicium, du nitrure de silicium, de l'oxynitrure de silicium, du nitrure d'aluminium (AIN), et/ou de l'oxyde de tantale (Ta₂O₅), ou un empilement de couches formées d'au moins deux desdits matériaux ;
- le substrat receveur comprend du silicium, du silicium, du verre, du quartz, du saphir, une céramique, et/ou du nitrure d'aluminium polycristallin ;
- le substrat receveur est un substrat de silicium incluant une couche de piégeage de charges comprenant du silicium polycristallin, du carbure de silicium, du silicium amorphe et/ou du silicium poreux ;
- le substrat support et le substrat receveur comprennent des matériaux présentant une différence de coefficient de dilatation thermique inférieure ou égale à 5% en valeur absolue ;
   - le substrat support et le substrat receveur sont formés d'un même matériau ;
   - la couche transférée présente une épaisseur comprise entre 30 nm et 1,5 µm.

### Brève description des dessins

D'autres caractéristiques et avantages de ce procédé ressortiront de la description détaillée qui va suivre, en référence aux dessins annexés, sur lesquels :
La figure 1A est un schéma de principe de l'assemblage du substrat donneur et du substrat support.
La figure 1B est un schéma de principe de l'assemblage du substrat donneur et du substrat support, après amincissement du substrat donneur.
La figure 2A illustre schématiquement l'opération de détourage du substrat donneur avant collage sur le substrat support.
La figure 2B est une vue en coupe de la périphérie de l'hétérostructure après le collage du substrat donneur détouré de la figure 2A sur le substrat support.
La figure 2C est une vue en coupe de la périphérie de l'hétérostructure après l'amincissement du substrat donneur.
La figure 3A illustre schématiquement l'opération de détourage du substrat donneur après son collage et son amincissement sur le substrat support.
La figure 3B est une vue en coupe de la périphérie de l'hétérostructure après le détourage de la figure 3A.
La figure 4A illustre schématiquement l'opération de détourage du substrat donneur après son collage sur le substrat support.
La figure 4B est une vue en coupe de la périphérie du substrat donneur avant son amincissement et du substrat support après le détourage de la figure 4A.
La figure 4C est une vue en coupe de la périphérie de l'hétérostructure après l'amincissement du substrat donneur détouré de la figure 4B.
La figure 5A illustre de manière schématique un premier mode de réalisation du détourage.
La figure 5B illustre de manière schématique un deuxième mode de réalisation du détourage.
La figure 6A est une vue en coupe d'une hétérostructure formée par un procédé selon un mode de réalisation de l'invention.
La figure 6B est une vue en coupe de la formation d'une zone de fragilisation dans l'hétérostructure de la figure 6A pour y délimiter une couche à transférer.
La figure 6C est une vue en coupe du collage de l'hétérostructure de la figure 6B sur un substrat receveur.
La figure 6D est une vue en coupe de la couche transférée sur le substrat receveur après détachement de l'hétérostructure de la figure 6C le long de la zone de fragilisation.
La figure 7A est une vue en coupe d'une hétérostructure formée par un procédé selon un mode de réalisation de l'invention.
La figure 7B est une vue en coupe de la formation d'une zone de fragilisation dans l'hétérostructure de la figure 7A pour y délimiter une couche à transférer.
La figure 7C est une vue en coupe du collage de l'hétérostructure de la figure 7B sur un substrat receveur.
La figure 7D est une vue en coupe de la couche transférée sur le substrat receveur après détachement de l'hétérostructure de la figure 7C le long de la zone de fragilisation.

Pour des raisons de lisibilité des figures, les dimensions des différents éléments n'ont pas nécessairement été représentés à l'échelle.

Des signes de référence identiques d'une figure à l'autre désignent des éléments identiques ou remplissant une même fonction, qui ne sont pas nécessairement décrits en détail à nouveau.

### Description détaillée de modes de réalisation

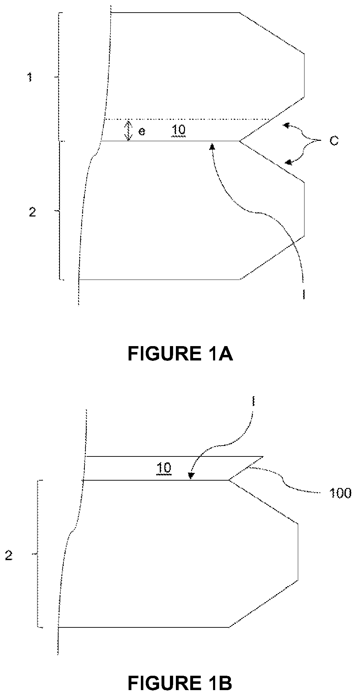

Les figures 1A et 1B illustrent le problème que l'invention cherche à éviter lors de la fabrication d'une hétérostructure destinée notamment à remplir la fonction de pseudo-substrat donneur en vue d'un transfert ultérieur d'une portion dudit pseudo-substrat donneur sur un substrat receveur.

La formation de l'hétérostructure comprend le collage d'un substrat donneur 1 d'un premier matériau et d'un substrat support 2 d'un second matériau.

Le premier matériau peut être un matériau destiné à être transféré ultérieurement sur le substrat donneur mais qui présente avec le matériau du substrat receveur une différence de coefficient de dilatation thermique empêchant un transfert direct, comme expliqué en introduction. Par exemple, mais de manière non limitative, le premier matériau peut être un matériau piézoélectrique, tel que du niobate de lithium (LiNbO₃), du tantalate de lithium (LiTaO₃), ou un matériau semi-conducteur, tel que du nitrurgallium (GaN), du phosphure d'indium (InP), de l'arséniure de gallium (GaAs), ...

Le second matériau est généralement différent du premier matériau. La fonction du substrat support est de supporter temporairement le substrat donneur jusqu'au transfert d'une portion du substrat donneur sur le substrat receveur. Le second matériau peut être avantageusement choisi pour présenter avec le matériau du substrat receveur une faible différence de coefficient de dilatation thermique, c'est-à-dire typiquement une différence de coefficient de dilatation thermique nulle ou en valeur absolue inférieure à 5%. Par exemple, mais de manière non limitative, le second matériau peut être du silicium, du verre, du quartz, du saphir, une céramique, du nitrure d'aluminium (AIN) polycristallin. Le choix du second matériau peut être effectué en fonction du matériau du substrat receveur pour assurer l'accord des coefficients de dilatation thermique desdits matériaux. Dans un mode de réalisation préféré, le second matériau est identique à celui du substrat receveur.

Comme illustré sur la figure 1A, les substrats 1 et 2 présentent chacun un chanfrein périphérique C sur chacune de leurs faces principales. En général, le chanfrein présente un angle de 22 à 40° par rapport à la surface principale de chaque substrat et s'étend sur une hauteur de l'ordre de 200 à 300 µm dans le sens de l'épaisseur du substrat et une largeur de l'ordre de 200 à 300 µm dans la direction radiale du substrat.

Pour la formation de l'hétérostructure, le substrat donneur 1 doit être aminci de sorte à transférer une couche 10 d'épaisseur e sur le substrat support 2. Ledit amincissement peut être réalisé par une gravure du substrat donneur par la face opposée à l'interface de collage I avec le substrat support 2. De manière particulièrement avantageuse, la gravure peut être réalisée en plusieurs étapes, avec une finesse croissante. Ainsi, une première partie du substrat donneur peut être retirée par un meulage (« grinding » selon la terminologie anglo-saxonne) grossier, qui permet de réduire rapidement l'épaisseur du substrat donneur. Puis, un meulage plus fin peut être mis en œuvre pour continuer à réduire l'épaisseur du substrat donneur, mais en diminuant la rugosité de la surface dudit substrat donneur. Enfin, un polissage mécano-chimique (CMP, acronyme du terme anglo-saxon « Chemical Mechanical Polishing) peut être réalisé pour lisser la surface du substrat donneur aminci de sorte à atteindre la rugosité souhaitée. Comme mentionné plus bas, le meulage fin peut ne pas être réalisé directement après le meulage grossier mais après une autre étape du procédé.

Par exemple, le substrat donneur 1 peut présenter une épaisseur de l'ordre de quelques centaines de micromètres, et le substrat donneur aminci 10 peut présenter une épaisseur e de quelques dizaines de micromètres, par exemple comprise entre 10 et 100 µm, de préférence entre 10 et 50 µm.

Dans ce cas, comme on le voit sur la figure 1A, l'épaisseur e est inférieure à l'épaisseur du chanfrein C du substrat donneur.

Par conséquent, comme illustré sur la figure 1B qui représente l'assemblage du substrat donneur 1 et du substrat support 2 après l'amincissement du substrat donneur, le substrat donneur aminci 10 présente un bord périphérique 100 comprenant un angle vif au niveau de la face principale opposée à l'interface I de collage. Un tel angle vif est susceptible de se briser lors de la manipulation de l'hétérostructure. Ce phénomène de casse, appelé « flaking » dans la terminologie anglo-saxonne, est particulièrement nocif car les débris du substrat donneur aminci risquent de contaminer l'ensemble de la ligne de fabrication utilisant l'hétérostructure.

Pour éviter un tel phénomène, l'invention propose de retirer une portion périphérique du substrat donneur, avant ou après le collage dudit substrat donneur sur le substrat support. Un tel retrait sera également appelé « détourage » (« edge trimming » ou « edge grinding » selon la terminologie anglo-saxonne) dans le présent texte.

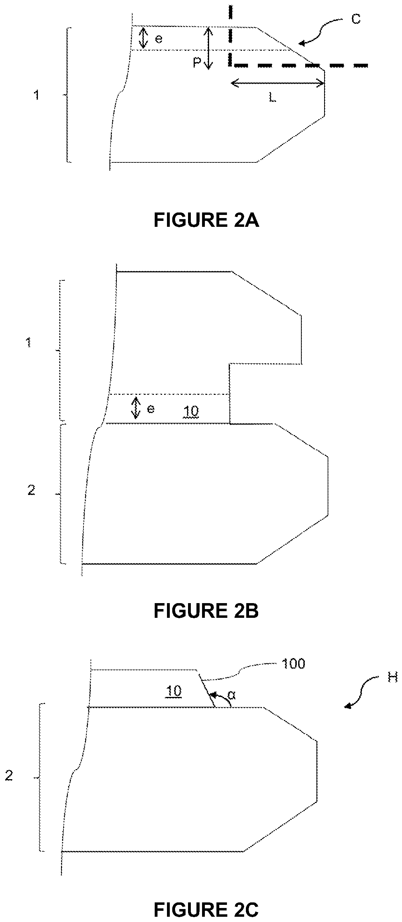

Ledit détourage vise à supprimer le chanfrein du substrat donneur aminci ou non et à former un bord droit, de préférence incliné d'un angle α (représenté sur la figure 2C) supérieur ou égal à 90° par rapport à la face principale du substrat support pour éviter tout coincement de particules dans le coin entre la face principale du substrat support et le bord du substrat donneur. Dans le cas d'un angle obtus (α > 90°C), on choisira cependant un angle relativement proche de 90°, par exemple compris entre 90 et 135°, afin qu'éviter que la couche transférée ultérieurement du substrat donneur sur le substrat receveur ne forme une lame cassante.

A cet effet, dans certains modes de réalisation, la largeur de la portion périphérique retirée (notée L sur les figures 2A, 3A et 4A qui seront décrites plus bas) est supérieure ou égale à la largeur du chanfrein du substrat donneur.

Par ailleurs, comme expliqué en détail plus bas, la largeur de la portion périphérique retirée peut dépendre du mode de collage du substrat donneur sur le substrat support.

Un premier mode de collage est un collage par adhésion moléculaire, dans lequel le substrat donneur et le substrat support, éventuellement recouverts d'une couche d'oxyde, sont en contact direct, l'adhésion étant assurée par des forces intermoléculaires à l'interface de collage, notamment de type Van der Walls. De manière connue en elle-même, un tel collage peut nécessiter une préparation des surfaces à coller, notamment un polissage, un nettoyage, et/ou une activation par plasma.

Un second mode de collage est un collage par l'intermédiaire d'une couche polymérique, telle que décrite notamment dans le document WO 2019/186032. Ladite couche polymérique peut être formée par dépôt d'une couche photo-polymérisable sur la surface de l'un au moins des substrats, le collage des substrats par l'intermédiaire de ladite couche photo-polymérisable, puis l'irradiation de l'assemblage par un flux lumineux dont la longueur d'onde est choisie pour présenter un faible coefficient d'absorption vis-à-vis de l'un des substrats. Ainsi, le flux lumineux traverse ledit substrat sans être absorbé et atteint la couche adhésive, permettant ainsi sa polymérisation. Par exemple, lorsque le substrat donneur est en un matériau piézoélectrique, le flux lumineux peut présenter une longueur d'onde comprise entre 320 et 365 nm et être appliqué au travers du substrat donneur.

En pratique, la couche polymérique peut être formée comme suit.

Une couche adhésive photo-polymérisable est déposée sur la surface de l'un au moins des substrats. Le dépôt peut avantageusement être effectué par enduction centrifuge, ou « spin coating » en terminologie anglo-saxonne. Cette technique consiste à faire tourner le substrat sur lequel est prévu le dépôt de la couche photo-polymérisable sur lui-même à une vitesse sensiblement constante et relativement élevée, afin d'étaler ladite couche photo-polymérisable de façon uniforme sur l'ensemble de la surface du substrat par force centrifuge. A cet effet, le substrat est typiquement posé et maintenu par tirage du vide sur un plateau tournant. L'homme du métier est en mesure de déterminer les conditions opératoires, telles que le volume d'adhésif déposé sur la surface du substrat, la vitesse de rotation du substrat, et la durée minimale du dépôt en fonction de l'épaisseur souhaitée pour la couche adhésive. L'épaisseur de la couche adhésive photo-polymérisable déposée est typiquement comprise entre 2 et 8 µm.

Selon un exemple non limitatif, la couche adhésive photo-polymérisable commercialisée sous la référence « NOA 61 » par la société NORLAND PRODUCTS peut être utilisée dans la présente invention.

Le substrat donneur et le substrat support sont ensuite collés par l'intermédiaire de ladite couche photo-polymérisable pour former une hétérostructure. Le collage est de préférence réalisé à température ambiante, soit environ 20°C. Il est cependant possible de réaliser le collage à chaud à une température comprise entre 20°C et 50°C, et de manière davantage préférée entre 20°C et 30 °C. De plus, l'étape de collage est avantageusement effectuée sous vide, ce qui permet de désorber l'eau des surfaces formant l'interface de collage, c'est-à-dire la surface de la couche adhésive et la surface du substrat de manipulation ou du substrat piézoélectrique.

On soumet ensuite l'hétérostructure à une irradiation par un flux lumineux, afin de polymériser la couche adhésive. La source lumineuse est de préférence un laser. Le rayonnement lumineux, ou flux lumineux, est de préférence un rayonnement ultra-violet (UV). En fonction de la composition de la couche adhésive, on choisira de préférence un rayonnement UV présentant une longueur d'onde comprise entre 320 nm et 365 nm. L'irradiation est effectuée en exposant la face libre du substrat donneur au rayonnement lumineux incident. Ainsi, le rayonnement lumineux pénètre dans l'hétérostructure depuis la face libre du substrat donneur, traverse le substrat donneur, jusqu'à atteindre la couche adhésive, provoquant ainsi la polymérisation de ladite couche adhésive. La polymérisation de la couche adhésive permet de former une couche polymère qui assure la cohésion mécanique de l'hétérostructure, en maintenant collés ensemble le substrat donneur et le substrat support.

L'irradiation de l'hétérostructure donne lieu à un processus thermique selon lequel le substrat donneur, traversé par le rayonnement, peut absorber en partie l'énergie du rayonnement et s'échauffer. Un échauffement trop important serait susceptible de déstabiliser la structure du substrat donneur si celui-ci est piézoélectrique, ce qui pourrait aboutir à une dégradation des propriétés physiques et chimiques de la couche piézoélectrique. En outre, un échauffement trop important pourrait occasionner une déformation du substrat donneur et du substrat support en raison de leur différence de coefficient de dilatation thermique. Afin d'éviter un échauffement trop important du substrat donneur, l'irradiation est avantageusement effectuée de manière impulsionnelle, c'est-à-dire en exposant l'hétérostructure à une pluralité d'impulsions de rayons lumineux. Chaque impulsion est réalisée pendant un temps d'irradiation déterminé, qui peut être égal ou différent d'une impulsion à l'autre. Les impulsions sont espacées dans le temps par un temps de repos déterminé pendant lequel l'hétérostructure n'est pas exposée aux rayons lumineux. L'homme du métier est en mesure de déterminer le temps d'irradiation de chaque impulsion, le temps de repos entre chaque impulsion, ainsi que le nombre d'impulsions à réaliser pour polymériser complètement la couche adhésive. Ainsi, par exemple, on pourra mettre en œuvre une dizaine d'impulsions durant 10 secondes chacune, séparées par des temps de repos durant également 10 secondes chacun.

La couche adhésive polymérisée permet donc de coller le substrat donneur et le substrat support sans les exposer à un budget thermique qui serait susceptible de les déformer, ce qui permet de conférer à l'hétérostructure une tenue mécanique suffisante pour le transfert ultérieur d'une couche piézoélectrique. L'épaisseur de la couche adhésive polymérisée est de préférence comprise entre 2 et 8 µm. Cette épaisseur dépend notamment du matériau constitutif de la couche adhésive photo-polymérisable déposée avant collage, de l'épaisseur de ladite couche adhésive photo-polymérisable, et des conditions expérimentales d'irradiation.

Dans un mode de réalisation alternatif, notamment lorsque ni le substrat donneur ni le substrat support n'est suffisamment transparent au flux lumineux nécessaire pour polymériser la couche photo-polymérisable, on peut employer une colle polymérique apte à polymériser sous l'effet d'un recuit à basse température (c'est-à-dire typiquement inférieur à 100°C).

Ce second mode de collage mettant en oeuvre une couche polymérique (qu'elle soit polymérisable par irradiation ou par recuit à basse température) est particulièrement avantageux dans le contexte de la présente invention, car il permet de réduire la largeur de la portion périphérique du substrat donneur, et ainsi de réduire la durée de l'opération de détourage.

En effet, dans le cas du collage par une couche polymère, la largeur de la portion périphérique à retirer du substrat donneur peut être comprise entre 300 et 1000 µm, de préférence entre 300 et 500 µm à partir du bord dudit substrat. Par bord du substrat, on entend dans le présent texte le bord le plus externe du substrat, hors de la portion chanfreinée ; en d'autres termes, le bord du substrat définit le diamètre maximal du substrat.

Dans le cas d'un collage par adhésion moléculaire, la largeur de la portion périphérique à retirer du substrat donneur peut être comprise entre 1 et 3 mm, de préférence entre 2 et 3 mm à partir du bord du substrat donneur.

Cette différence entre la largeur détourée selon les deux modes de collage s'explique par le fait que, dans le cas d'un collage par adhésion moléculaire, il existe une couronne périphérique présentant, au-delà du chanfrein, une largeur de l'ordre de 1 ou 2 mm sur laquelle il est difficile d'assurer un collage continu entre les deux substrats. Ceci impose de détourer le substrat donneur sur une largeur supérieure ou égale à cette couronne, de manière à assurer un collage continu sur l'ensemble de la surface des substrats.

Dans le cas d'un collage par une couche polymère, le collage est assuré de manière continue par la couche polymère jusqu'au chanfrein, ce qui permet de détourer le substrat donneur sur une largeur plus faible que dans le cas du collage par adhésion moléculaire, cette largeur pouvant être simplement légèrement supérieure à celle du chanfrein. Ceci se traduit par une perte moins importante du premier matériau.

Quel que soit le mode de collage du substrat donneur sur le substrat support, le détourage du substrat donneur peut être réalisé à différents stades de la fabrication de l'hétérostructure, la largeur de la portion périphérique retirée étant choisie en fonction du mode de collage.

Dans un premier mode de réalisation, illustré sur les figures 2A-2C, le détourage est réalisé avant le collage du substrat donneur sur le substrat support.

La figure 2A illustre schématiquement l'opération de détourage du substrat donneur avant collage sur le substrat support, le trait en pointillés épais délimitant la portion périphérique retirée lors du détourage. Dans cette opération, il n'est pas nécessaire d'effectuer le détourage sur toute l'épaisseur du substrat donneur. En effet, le substrat donneur étant destiné à être aminci après son collage sur le substrat support, il suffit d'effectuer le détourage sur une profondeur P supérieure à l'épaisseur e du substrat donneur visée après l'amincissement, à partir de la face du substrat donneur destinée à être collée sur le substrat support. Par ailleurs, comme expliqué plus haut, la largeur L de la portion périphérique retirée est supérieure à la largeur du chanfrein C.

La figure 2B est une vue en coupe de la périphérie de l'hétérostructure après le collage du substrat donneur 1 détouré de la figure 2A sur le substrat support 2. Bien qu'aucune couche de collage ne soit représentée sur cette figure, une couche polymérique telle que décrite ci-dessus peut être utilisée pour assurer le collage entre les deux substrats, en alternative à un collage par adhésion moléculaire.

La portion 10 du substrat donneur résultant de l'amincissement est délimitée schématiquement par une ligne pointillée, ladite ligne représentant la surface du substrat donneur après l'amincissement.

La figure 2C est une vue en coupe de la périphérie de l'hétérostructure après l'amincissement du substrat donneur. On observe donc que, contrairement au cas de la figure 1B, le bord 100 du substrat donneur aminci 10 forme un angle droit ou obtus par rapport à la surface du substrat support et est donc moins susceptible de se briser.

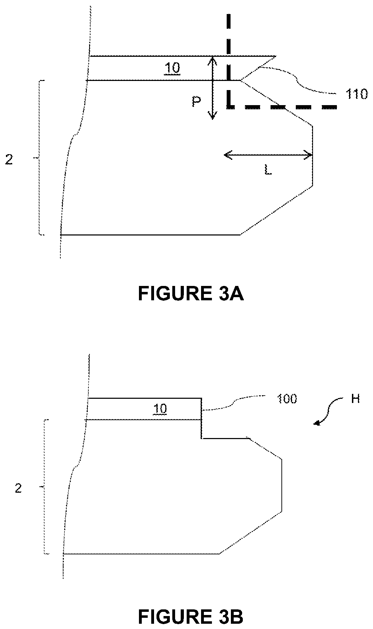

Dans un second mode de réalisation, illustré sur les figures 3A-3B, le détourage est réalisé après le collage et l'amincissement du substrat donneur sur le substrat support.

La figure 3A illustre schématiquement le détourage du substrat donneur 10 aminci sur le substrat support 2 (le substrat donneur ayant été au préalable collé sur le substrat support puis aminci jusqu'à l'épaisseur souhaitée). Bien qu'aucune couche de collage ne soit représentée sur cette figure, une couche polymérique telle que décrite ci-dessus peut être utilisée pour assurer le collage entre les deux substrats, en alternative à un collage par adhésion moléculaire.

Le trait en pointillés épais délimite la portion périphérique retirée lors du détourage. Dans cette opération, le détourage est réalisé sur une profondeur P au moins égale à l'épaisseur du substrat donneur aminci 10. De préférence, le détourage s'étend au moins en partie dans l'épaisseur du substrat support 2. En effet, même si la surface du substrat support présente une rugosité résultant de l'opération de détourage, celle-ci n'est pas préjudiciable dans la mesure où cette surface n'est pas destinée à être collée sur le substrat receveur lors de l'utilisation ultérieure de l'hétérostructure en tant que pseudo-substrat donneur. Par ailleurs, comme expliqué plus haut, la largeur L de la portion périphérique retirée est supérieure à la largeur du chanfrein C.

Eventuellement, le détourage peut être réalisé alors que le substrat donneur n'a été aminci qu'en partie. Ainsi, par exemple, le substrat donneur peut subir une première étape d'amincissement par un meulage grossier, puis l'étape de détourage et une seconde étape d'amincissement par un meulage fin ou un polissage mécano-chimique, permettant de réduire la rugosité de la surface du substrat donneur aminci. Cet ordre particulier des étapes permet de réaliser le détourage alors que le substrat donneur est encore suffisamment épais pour ne pas risquer d'être endommagé, notamment pour ne pas risquer de perte de cohésion dudit substrat donneur lors du détourage. Par exemple, s'agissant d'un substrat donneur piézoélectrique, il est avantageux de conserver une épaisseur de 60 µm à l'issue du meulage grossier afin de réaliser le détourage, puis de réaliser le meulage fin jusqu'à atteindre une épaisseur de l'ordre de 10 à 20 µm.

La figure 3B est une vue en coupe de la périphérie de l'hétérostructure après l'amincissement du substrat donneur. On observe donc que, contrairement au cas de la figure 1B, le bord 100 du substrat donneur aminci 10 forme un angle droit (ou obtus) avec la surface du substrat support et est donc moins susceptible de se briser.

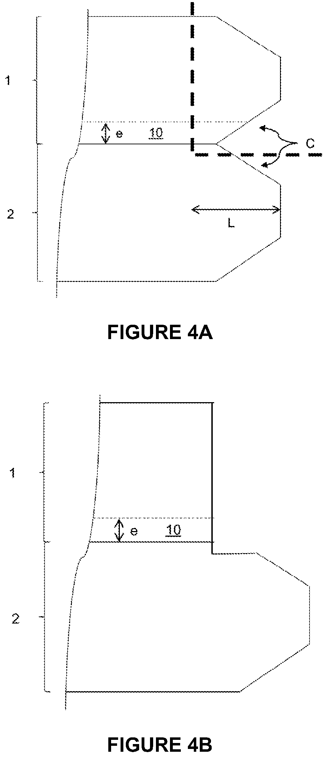

Dans un troisième mode de réalisation, illustré sur les figures 4A-4C, le détourage est réalisé entre le collage et l'amincissement du substrat donneur sur le substrat support.

La figure 4A illustre schématiquement l'opération de détourage du substrat donneur après son collage sur le substrat support, mais avant l'amincissement dudit substrat donneur (le substrat donneur ayant été au préalable collé sur le substrat support puis aminci jusqu'à l'épaisseur souhaitée). Bien qu'aucune couche de collage ne soit représentée sur cette figure, une couche polymérique telle que décrite ci-dessus peut être utilisée pour assurer le collage entre les deux substrats, en alternative à un collage par adhésion moléculaire.

Le trait en pointillés épais délimite la portion périphérique retirée lors du détourage. Contrairement au mode de réalisation des figures 2A-2B, le détourage est réalisé sur toute l'épaisseur du substrat donneur 1. De préférence, le détourage s'étend également au moins en partie dans l'épaisseur du substrat support 2. En effet, même si la surface du substrat support présente une rugosité résultant de l'opération de détourage, celle-ci n'est pas préjudiciable dans la mesure où cette surface n'est pas destinée à être collée sur le substrat receveur lors de l'utilisation ultérieure de l'hétérostructure en tant que pseudo-substrat donneur. Par ailleurs, comme expliqué plus haut, la largeur L de la portion périphérique retirée est supérieure à la largeur du chanfrein C.

La figure 4B est une vue en coupe de la périphérie du substrat donneur avant son amincissement et du substrat support après le détourage de la figure 4A.

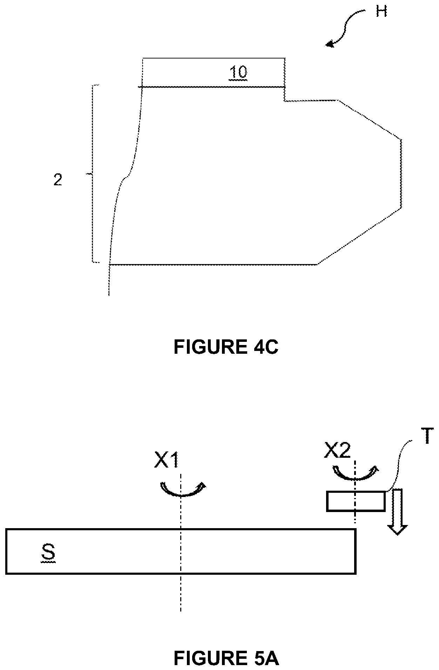

La figure 4C est une vue en coupe de la périphérie de l'hétérostructure après l'amincissement du substrat donneur. On observe donc que, contrairement au cas de la figure 1B, le bord 100 du substrat donneur aminci 10 forme un angle droit (ou obtus) avec la surface du substrat support et est donc moins susceptible de se briser.

Il existe différentes techniques pour réaliser le détourage.

Selon un premier mode de réalisation, illustré sur la figure 5A, le substrat ou l'assemblage de substrats destiné à être détouré est positionné sur un support S entraîné en rotation autour de l'axe X1 de révolution du substrat ou de l'assemblage de substrats. Un outil tranchant T, tel qu'une roue abrasive, par exemple une roue diamantée, est entraîné en rotation autour d'un axe X2 parallèle à l'axe X1 et est amené en regard de la portion périphérique à retirer. Ledit outil est progressivement déplacé vers le substrat ou de l'assemblage de substrats dans une direction parallèle à l'axe X1 (représentée par la flèche), afin de meuler progressivement le matériau du substrat ou de l'assemblage de substrats qu'il rencontre.

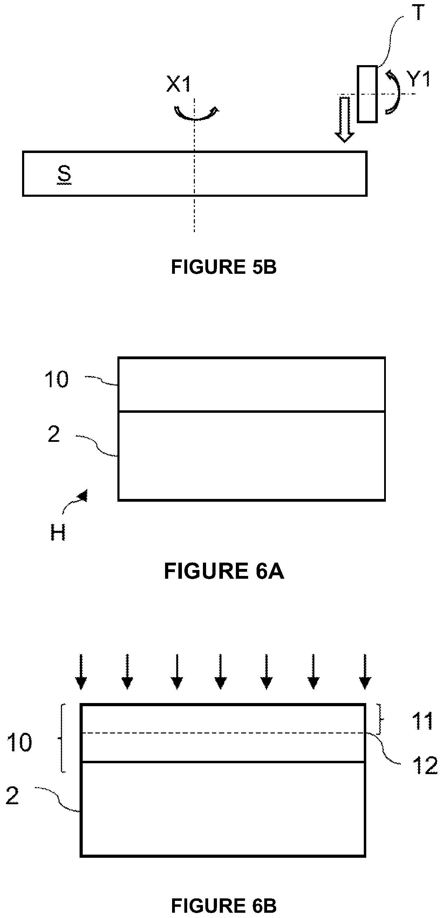

Selon un second mode de réalisation, illustré sur la figure 5B, le substrat ou l'assemblage de substrats destiné à être détouré est positionné sur un support S entraîné en rotation autour de l'axe X1 de révolution du substrat ou de l'assemblage de substrats. Un outil tranchant T, tel qu'une roue abrasive, est entraîné en rotation autour d'un axe Y1 perpendiculaire à l'axe X1 et est amené en regard de la portion périphérique à retirer. Ledit outil est progressivement déplacé vers le substrat ou de l'assemblage de substrats dans une direction parallèle à l'axe X1, afin de meuler progressivement le matériau du substrat ou de l'assemblage de substrats qu'il rencontre. Eventuellement, selon la largeur de la portion périphérique à retirer, l'outil T peut également être déplacé dans une direction parallèle à l'axe Y1 afin de meuler progressivement le matériau du substrat ou de l'assemblage de substrats qu'il rencontre dans la direction radiale.

Quel que soit le mode de réalisation employé, le détourage a pour effet d'écrouir localement le matériau meulé par l'outil, de sorte que la surface exposée à l'issue du détourage peut présenter une certaine rugosité ou des défauts. Il peut alors être avantageux de procéder à un polissage, par exemple un polissage mécano-chimique (CMP) permettant de retirer la zone écrouie et d'améliorer l'état de surface du substrat donneur, afin d'éviter les défauts de collage lors du transfert ultérieur sur un substrat receveur.

L'hétérostructure ainsi formée est utilisée en tant que pseudo-substrat donneur pour transférer une portion du substrat donneur sur un substrat receveur. Grâce à son bord formant un angle droit ou obtus par rapport à la surface du substrat support, le substrat donneur aminci est beaucoup moins cassant et peut être manipulé commodément pour la mise en œuvre du procédé de transfert.

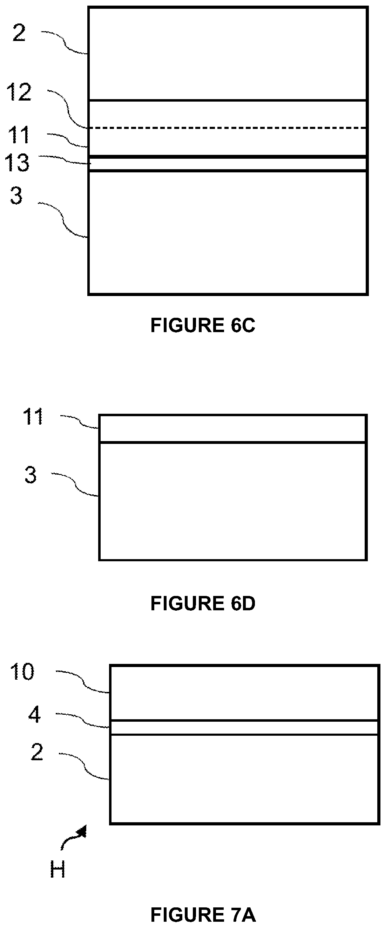

On va maintenant décrire, en référence aux figures 6A-6E et 7A-7E, deux modes de réalisation d'un procédé de transfert d'une couche de ladite hétérostructure sur un substrat receveur.

Le substrat receveur peut être choisi en fonction des propriétés électriques et/ou thermiques de la structure finale comprenant la couche transférée et le substrat receveur. Par exemple, le substrat receveur peut comprendre du silicium, du silicium, du verre, du quartz, du saphir, une céramique, et/ou du nitrure d'aluminium polycristallin. Dans certains modes de réalisation, notamment concernant les substrats pour applications radiofréquences, le substrat receveur peut être un substrat de silicium comprenant une couche de piégeage de charges, par exemple une couche de silicium polycristallin, ou éventuellement du carbure de silicium, du silicium amorphe et/ou du silicium poreux.

De manière particulièrement avantageuse, le substrat support et le substrat receveur peuvent être en des matériaux présentant une différence de coefficient de dilatation thermique inférieure ou égale à 5% en valeur absolue, de sorte à permettre un équilibrage des contraintes de part et d'autre du substrat donneur aminci au cours du procédé de transfert, évitant ainsi une déformation dudit substrat donneur aminci. De préférence, le substrat support et le substrat receveur peuvent être formés d'un même matériau.

En référence à la figure 6A, on fournit une hétérostructure H comprenant un substrat donneur aminci 10 détouré selon l'un quelconque des modes de réalisation décrits plus haut, et un substrat support 2, lesdits substrats étant collés par adhésion moléculaire. Pour simplifier les figures, la portion détourée du substrat donneur et, le cas échéant, du substrat support, n'a pas été représentée. La largeur de ladite portion détourée est typiquement comprise entre 1 et 3 mm, de préférence entre 2 et 3 mm à partir du bord du substrat donneur.

En référence à la figure 6B, on implante dans le substrat donneur aminci 10 des espèces atomiques, telles que de l'hydrogène et/ou de l'hélium, afin de former une zone de fragilisation 12 qui délimite une couche 11 du premier matériau.

En référence à la figure 6C, on colle l'hétérostructure (du côté de la couche 11 à transférer) sur le substrat receveur 3. Dans certains modes de réalisation, une couche intermédiaire 13 est formée sur l'hétérostructure et/ou le substrat receveur. Ladite couche intermédiaire peut avoir pour fonction d'améliorer la tenue du collage et/ou de contribuer aux propriétés électriques et/ou thermiques de la structure finale. Par exemple, la couche intermédiaire peut comprendre de l'oxyde de silicium, du nitrure de silicium, de l'oxynitrure de silicium, du nitrure d'aluminium (AIN), ou de l'oxyde de tantale (Ta₂O₅), voire un empilement d'au moins deux de ces matériaux. Dans d'autres modes de réalisation, on se dispense de la couche intermédiaire pour procéder à un collage direct entre l'hétérostructure et le substrat receveur.

Eventuellement, on met en œuvre un traitement thermique visant à augmenter l'énergie de collage.

En référence à la figure 6D, on détache le substrat donneur aminci 10 le long de la zone de fragilisation 12, de sorte à transférer la couche 11 du premier matériau sur le substrat receveur.

En référence à la figure 7A, on fournit une hétérostructure H comprenant un substrat donneur aminci 10 détouré selon l'un quelconque des modes de réalisation décrits plus haut, et un substrat support 2, lesdits substrats étant collés par une couche polymérique 4. Pour simplifier les figures, la portion détourée du substrat donneur et, le cas échéant, du substrat support, n'a pas été représentée. La largeur de ladite portion détourée est typiquement comprise entre 300 et 1000 µm, de préférence entre 300 et 500 µm à partir du bord du substrat donneur.

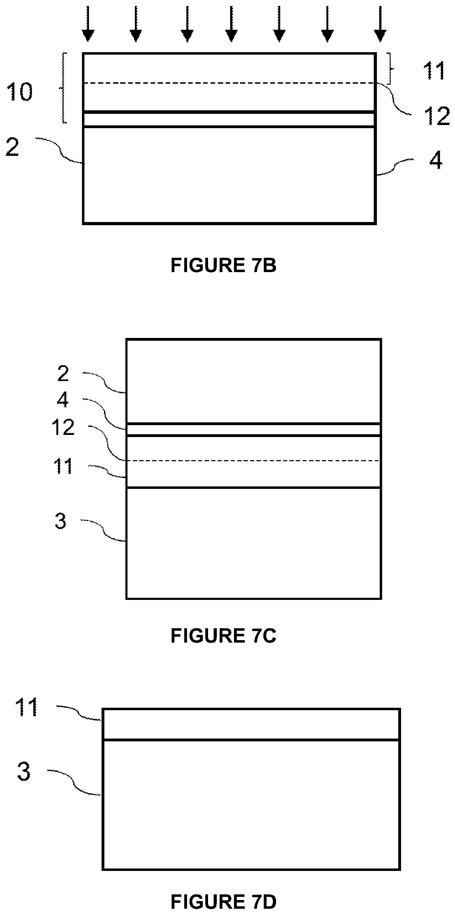

En référence à la figure 7B, on implante dans le substrat donneur aminci 10 des espèces atomiques, telles que de l'hydrogène et/ou de l'hélium, afin de former une zone de fragilisation 12 qui délimite une couche 11 du premier matériau.

En référence à la figure 7C, on colle l'hétérostructure (du côté de la couche 11 à transférer) sur le substrat receveur 3. Bien qu'aucune couche intermédiaire ne soit illustrée entre l'hétérostructure et le substrat receveur, une couche intermédiaire telle que décrite en référence à la figure 6C peut être formée à l'interface.

Eventuellement, on met en œuvre un traitement thermique visant à augmenter l'énergie de collage. Ledit traitement thermique est avantageusement réalisé à une température inférieure à 300°C afin de ne pas dégrader la couche polymère.

En référence à la figure 7D, on détache le substrat donneur aminci 10 le long de la zone de fragilisation 12, de sorte à transférer la couche 11 du premier matériau sur le substrat receveur 3.

Par l'un de ces procédés de transfert, on peut notamment former une structure de type piézoélectrique sur isolant, comprenant successivement une couche mince piézoélectrique présentant une épaisseur de l'ordre de quelques micromètres, une couche d'oxyde de silicium, une couche de piégeage de charges et un substrat de silicium.

## Revendications

1. Procédé de transfert d'une couche d'une hétérostructure (H) sur un substrat receveur (3), comprenant les étapes successives suivantes :
- formation de l'hétérostructure, comprenant les étapes de :
- fourniture d'un substrat donneur (1) d'un premier matériau et d'un substrat support (2) d'un second matériau,
- collage du substrat donneur (1) sur le substrat support (2),
- amincissement du substrat donneur (1), de sorte à former ladite hétérostructure (H) comprenant le substrat donneur aminci (10) sur le substrat support (2),
- retrait d'une portion périphérique du substrat donneur (1, 10),
- formation d'une zone de fragilisation (12) dans le substrat donneur aminci (10) de sorte à délimiter une couche (11) du premier matériau à transférer,
- collage de ladite hétérostructure (H) sur un substrat receveur (3), la couche (11) du premier matériau à transférer étant située à l'interface de collage,
- détachement du substrat donneur (10) le long de la zone de fragilisation (12) de sorte à transférer la couche (11) du premier matériau sur le substrat receveur (3).

2. Procédé selon la revendication 1, dans lequel l'étape de retrait de la portion périphérique du substrat donneur (1) est réalisée avant le collage du substrat donneur (1) sur le substrat support (2).

3. Procédé selon la revendication 1, dans lequel l'étape de retrait de la portion périphérique du substrat donneur (1) est réalisée après le collage du substrat donneur sur le substrat support.

4. Procédé selon la revendication 3, dans lequel le retrait de la portion périphérique du substrat donneur comprend en outre un retrait d'une portion périphérique du substrat support (2) en regard dudit substrat donneur (1).

5. Procédé selon l'une des revendications 3 ou 4, dans lequel l'étape de retrait de la portion périphérique du substrat donneur (1) est réalisée après au moins une partie de l'amincissement du substrat donneur.

6. Procédé selon l'une des revendications 1 à 5, dans lequel le substrat donneur (1, 10) est collé sur le substrat support (2) par une couche de collage polymérique (4).

7. Procédé selon la revendication 6, dans lequel la portion périphérique retirée du substrat donneur (1, 10) présente une largeur comprise entre 300 et 1000 µm, de préférence entre 300 et 500 µm à partir du bord du substrat donneur.

8. Procédé selon l'une des revendications 1 à 5, dans lequel le substrat donneur (1, 10) est collé sur le substrat support (2) par adhésion moléculaire.

9. Procédé selon la revendication 8, dans lequel la portion périphérique retirée du substrat donneur présente une largeur comprise entre 1 et 3 mm, de préférence entre 2 et 3 mm à partir du bord du substrat donneur.

10. Procédé selon l'une des revendications 1 à 9, dans lequel le retrait de la portion périphérique comprend :
- la mise en place du substrat donneur (1, 10) sur un support mobile en rotation autour d'un premier axe (X1) ;
- l'usinage du substrat donneur par une roue abrasive en rotation autour d'un second axe (X2) parallèle au premier axe (X1), la roue abrasive étant entraînée en outre en translation selon le second axe (X2).

11. Procédé selon l'une des revendications 1 à 9, dans lequel le retrait de la portion périphérique comprend :
- la mise en place du substrat donneur (1, 10) sur un support mobile en rotation autour d'un premier axe (X1) ;
- l'usinage du substrat donneur par une roue abrasive en rotation autour d'un second axe (Y1) perpendiculaire au premier axe (X1).

12. Procédé selon l'une des revendications 1 à 11, comprenant en outre une étape de polissage du substrat donneur (1, 10) après le retrait de la portion périphérique.

13. Procédé selon l'une des revendications 1 à 12, dans lequel le substrat donneur (1, 10) comprend un matériau piézoélectrique ou un matériau semi-conducteur.

14. Procédé selon l'une des revendications 1 à 13, dans lequel le substrat donneur aminci (10) présente une épaisseur comprise entre 10 et 100 µm, de préférence entre 10 et 50 µm.

15. Procédé selon l'une des revendications 1 à 13, dans lequel le substrat support (2) comprend du silicium, du verre, du quartz, du saphir, une céramique, et/ou du nitrure d'aluminium polycristallin.

16. Procédé selon l'une quelconque des revendications 1 à 15, dans lequel, avant le collage de l'hétérostructure (H) sur le substrat receveur (3), on forme une couche intermédiaire sur le substrat donneur (10) et/ou le substrat receveur (3).

17. Procédé selon la revendication 16, dans laquelle la couche intermédiaire comprend de l'oxyde de silicium, du nitrure de silicium, de l'oxynitrure de silicium, du nitrure d'aluminium, AlN, et/ou de l'oxyde de tantale, Ta₂O₅, ou ou un empilement de couches formées d'au moins deux desdits matériaux.

18. Procédé selon l'une quelconque des revendications 1 à 17, dans lequel le substrat receveur comprend du silicium, du silicium, du verre, du quartz, du saphir, une céramique, et/ou du nitrure d'aluminium polycristallin.

19. Procédé selon la revendication 18, dans lequel le substrat receveur est un substrat de silicium incluant une couche de piégeage de charges comprenant du silicium polycristallin, du carbure de silicium, du silicium amorphe et/ou du silicium poreux.

20. Procédé selon l'une des revendications 1 à 19, dans lequel le substrat support (2) et le substrat receveur (3) comprennent des matériaux présentant une différence de coefficient de dilatation thermique inférieure ou égale à 5% en valeur absolue.

21. Procédé selon la revendication 20, dans lequel le substrat support (2) et le substrat receveur (3) sont formés d'un même matériau.

22. Procédé selon l'une des revendications 1 à 21, dans lequel la couche transférée (11) présente une épaisseur comprise entre 30 nm et 1,5 µm.

## Patentansprüche

1. Verfahren zum Transfer einer Schicht einer Heterostruktur (H) auf ein Empfängersubstrat (3), das die folgenden aufeinanderfolgenden Schritte umfasst:
- Bilden der Heterostruktur, umfassend die Schritte:
- Bereitstellen eines Donorsubstrats (1) aus einem ersten Material und eines Trägersubstrats (2) aus einem zweiten Material,
- Kleben des Donorsubstrats (1) auf das Trägersubstrat (2),
- Ausdünnen des Donorsubstrats (1), um die Heterostruktur (H) zu bilden, die das ausgedünnte Donorsubstrat (10) auf dem Trägersubstrat (2) umfasst,
- Entfernen eines Umfangsabschnitts des Donorsubstrats (1, 10),
- Bilden einer Versprödungszone (12) in dem ausgedünnten Donorsubstrat (10), so dass eine Schicht (11) des ersten zu transferierenden Materials begrenzt wird,
- Kleben der Heterostruktur (H) auf ein Empfängersubstrat (3), wobei sich die Schicht (11) des ersten zu transferierenden Materials an der Klebegrenzfläche befindet,
- Ablösen des Donorsubstrats (10) entlang der Versprödungszone (12), so dass die Schicht (11) des ersten Materials auf das Empfängersubstrat (3) transferiert wird.

2. Verfahren nach Anspruch 1, wobei der Schritt des Entfernens des Umfangsabschnitts des Donorsubstrats (1) vor dem Kleben des Donorsubstrats (1) auf das Trägersubstrat (2) durchgeführt wird.

3. Verfahren nach Anspruch 1, wobei der Schritt des Entfernens des Umfangsabschnitts des Donorsubstrats (1) nach dem Kleben des Donorsubstrats auf das Trägersubstrat durchgeführt wird.

4. Verfahren nach Anspruch 3, wobei das Entfernen des Umfangsabschnitts des Donorsubstrats ferner ein Entfernen eines Umfangsabschnitts des Trägersubstrats (2) umfasst, der dem Donorsubstrat (1) zugewandt ist.

5. Verfahren nach einem der Ansprüche 3 oder 4, wobei der Schritt des Entfernens des Umfangsabschnitts des Donorsubstrats (1) nach mindestens einem Teil des Ausdünnens des Donorsubstrats durchgeführt wird.

6. Verfahren nach einem der Ansprüche 1 bis 5, wobei das Donorsubstrat (1, 10) durch eine polymere Klebeschicht (4) auf das Trägersubstrat (2) geklebt wird.

7. Verfahren nach Anspruch 6, wobei der vom Donorsubstrat (1, 10) entfernte Umfangsabschnitt eine Breite zwischen 300 und 1000 µm, vorzugsweise zwischen 300 und 500 µm, ab dem Rand des Donorsubstrats aufweist.

8. Verfahren nach einem der Ansprüche 1 bis 5, wobei das Donorsubstrat (1, 10) durch molekulare Adhäsion auf das Trägersubstrat (2) geklebt wird.

9. Verfahren nach Anspruch 8, wobei der vom Donorsubstrat entfernte Umfangsabschnitt eine Breite zwischen 1 und 3 mm, vorzugsweise zwischen 2 und 3 mm, ab dem Rand des Donorsubstrats aufweist.

10. Verfahren nach einem der Ansprüche 1 bis 9, wobei das Entfernen des Umfangsabschnitts umfasst:
- das Anordnen des Donorsubstrats (1, 10) auf einem Träger, der um eine erste Achse (X1) rotationsbeweglich ist;
- das Bearbeiten des Donorsubstrats durch ein Schleifrad, das um eine zweite Achse (X2) parallel zur ersten Achse (X1) dreht, wobei das Schleifrad ferner gemäß der zweiten Achse (X2) translatorisch angetrieben wird.

11. Verfahren nach einem der Ansprüche 1 bis 9, wobei das Entfernen des Umfangsabschnitt umfasst:
- das Anordnen des Donorsubstrats (1, 10) auf einem Träger, der um eine erste Achse (X1) rotationsbeweglich ist;
- das Bearbeiten des Donorsubstrats mit einem Schleifrad, das um eine zweite Achse (Y1) senkrecht zur ersten Achse (X1) dreht.

12. Verfahren nach einem der Ansprüche 1 bis 11, das ferner einen Schritt des Polierens des Donorsubstrats (1, 10) nach dem Entfernen des Umfangsabschnitts umfasst.

13. Verfahren nach einem der Ansprüche 1 bis 12, wobei das Donorsubstrat (1, 10) ein piezoelektrisches Material oder ein Halbleitermaterial umfasst.

14. Verfahren nach einem der Ansprüche 1 bis 13, wobei das ausgedünnte Donorsubstrat (10) eine Dicke zwischen 10 und 100 µm, vorzugsweise zwischen 10 und 50 µm, aufweist.

15. Verfahren nach einem der Ansprüche 1 bis 13, wobei das Trägersubstrat (2) Silizium, Glas, Quarz, Saphir, Keramik und/oder polykristallines Aluminiumnitrid umfasst.

16. Verfahren nach einem der Ansprüche 1 bis 15, wobei vor dem Kleben der Heterostruktur (H) auf das Empfängersubstrat (3) eine Zwischenschicht auf dem Donorsubstrat (10) und/oder dem Empfängersubstrat (3) gebildet wird.

17. Verfahren nach Anspruch 16, wobei die Zwischenschicht Siliziumoxid, Siliziumnitrid, Siliziumoxynitrid, Aluminiumnitrid, AIN und/oder Tantaloxid Ta₂O₅ oder einen Stapel von Schichten aus mindestens zwei der genannten Materialien umfasst.

18. Verfahren nach einem der Ansprüche 1 bis 17, wobei das Empfängersubstrat Silizium, Silizium, Glas, Quarz, Saphir, eine Keramik und/oder polykristallines Aluminiumnitrid umfasst.

19. Verfahren nach Anspruch 18, wobei das Empfängersubstrat ein Siliziumsubstrat ist, das eine ladungsfangende Schicht einschließt, die polykristallines Silizium, Siliziumkarbid, amorphes Silizium und/oder poröses Silizium umfasst.

20. Verfahren nach einem der Ansprüche 1 bis 19, wobei das Trägersubstrat (2) und das Empfängersubstrat (3) Materialien umfassen, die einen unterschiedlichen thermischen Ausdehnungskoeffizienten von 5% oder weniger als Absolutwert aufweisen.

21. Verfahren nach Anspruch 20, wobei das Trägersubstrat (2) und das Empfängersubstrat (3) aus demselben Material gebildet sind.

22. Verfahren nach einem der Ansprüche 1 bis 21, wobei die transferierte Schicht (11) eine Dicke zwischen 30 nm und 1,5 µm aufweist.

## Claims

1. Method for transferring a layer from a heterostructure **(H)** to a receiver substrate (3), comprising the following steps in succession:
- providing a donor substrate (1) of a first material and a carrier substrate (2) of a second material,
- bonding the donor substrate (1) to the carrier substrate (2),
- thinning the donor substrate (1), so as to form said heterostructure **(H)** comprising the thinned donor substrate (10) on the carrier substrate (2),
- removing a peripheral portion from the donor substrate (1, 10),
- forming a weakened region (12) in the thinned donor substrate (10) so as to delimit a layer (11) of the first material to be transferred,
- bonding said heterostructure **(H)** to a receiver substrate (3), the layer (11) of the first material to be transferred being located at the bonding interface,
- detaching the donor substrate (10) along the weakened region (12) so as to transfer the layer (11) of the first material to the receiver substrate (3).

2. Method according to Claim 1, wherein the step of removing the peripheral portion from the donor substrate (1) is carried out before the bonding of the donor substrate (1) to the carrier substrate (2).

3. Method according to Claim 1, wherein the step of removing the peripheral portion from the donor substrate (1) is carried out after the bonding of the donor substrate to the carrier substrate.

4. Method according to Claim 3, wherein the removal of the peripheral portion from the donor substrate further comprises removing a peripheral portion from the carrier substrate (2) facing said donor substrate (1).

5. Method according to one of Claims 3 and 4, wherein the step of removing the peripheral portion from the donor substrate (1) is carried out after the donor substrate has been at least partly thinned.

6. Method according to one of Claims 1 to 5, wherein the donor substrate (1, 10) is bonded to the carrier substrate (2) via a polymeric bonding layer (4).

7. Method according to Claim 6, wherein the width of the peripheral portion removed from the donor substrate (1, 10) is between 300 and 1000 µm, preferably between 300 and 500 µm from the edge of the donor substrate.

8. Method according to one of Claims 1 to 5, wherein the donor substrate (1, 10) is bonded to the carrier substrate (2) via molecular adhesion.

9. Method according to Claim 8, wherein the width of the peripheral portion removed from the donor substrate is between 1 and 3 mm, preferably between 2 and 3 mm from the edge of the donor substrate.

10. Method according to one of Claims 1 to 9, wherein the removal of the peripheral portion comprises:
- placing the donor substrate (1, 10) on a carrier that is rotatably movable about a first axis (X1);
- machining the donor substrate using an abrasive wheel rotating about a second axis (X2) parallel to the first axis (X1), the abrasive wheel further being driven in translation along the second axis (X2).

11. Method according to one of Claims 1 to 9, wherein the removal of the peripheral portion comprises:
- placing the donor substrate (1, 10) on a carrier that is rotatably movable about a first axis (X1);
- machining the donor substrate using an abrasive wheel rotating about a second axis (Y1) perpendicular to the first axis (X1).

12. Method according to one of Claims 1 to 11, further comprising a step of polishing the donor substrate (1, 10) after the removal of the peripheral portion.

13. Method according to one of Claims 1 to 12, wherein the donor substrate (1, 10) comprises a piezoelectric material or a semiconductor material.

14. Method according to one of Claims 1 to 13, wherein the thickness of the thinned donor substrate (10) is between 10 and 100 µm, preferably between 10 and 50 µm.

15. Method according to one of Claims 1 to 13, wherein the carrier substrate (2) comprises silicon, glass, quartz, sapphire, a ceramic, and/or polycrystalline aluminium nitride.

16. Method according to any one of Claims 1 to 15, wherein, before the bonding of the heterostructure (H) to the receiver substrate (3), an intermediate layer is formed on the donor substrate (10) and/or the receiver substrate (3).

17. Method according to Claim 16, wherein the intermediate layer comprises silicon oxide, silicon nitride, silicon oxynitride, aluminium nitride, AIN, and/or tantalum oxide Ta₂O₅, or a stack of layers formed of at least two of said materials.

18. Method according to any one of Claims 1 to 17, wherein the receiver substrate comprises silicon, silicon, glass, quartz, sapphire, a ceramic, and/or polycrystalline aluminium nitride.

19. Method according to Claim 18, wherein the receiver substrate is a silicon substrate including a charge-trapping layer comprising polycrystalline silicon, silicon carbide, amorphous silicon and/or porous silicon.

20. Method according to one of Claims 1 to 19, wherein the carrier substrate (2) and the receiver substrate (3) comprise materials exhibiting a difference in coefficient of thermal expansion smaller than or equal to 5% in terms of absolute value.

21. Method according to Claim 20, wherein the carrier substrate (2) and the receiver substrate (3) are formed of the same material.

22. Method according to one of Claims 1 to 21, wherein the thickness of the transferred layer (11) is between 30 nm and 1.5 µm.
